# EUROPÄISCHE PATENTSCHRIFT

(11) **EP 2 907 010 B1**
(45) Veröffentlichungstag und Bekanntmachung des Hinweises auf die Patenterteilung: **21.06.2017**
(21) Anmeldenummer: 13776794.3
(22) Anmeldetag: 14.10.2013
(51) Int. Cl.: B29C 45/14, G01R 27/26, G06F 3/044, G06F 3/045, H05K 1/11, H05K 1/18

(54) **FOLIE SOWIE KÖRPER MIT EINER SOLCHEN FOLIE**
FILM AND BODY WITH SUCH A FILM
FEUILLE ET ÉLÉMENT COMPRENANT UNE TELLE FEUILLE

(30) Priorität: 15.10.2012 DE 102012109820; 01.02.2013 DE 102013101064
(43) Veröffentlichungstag der Anmeldung: 19.08.2015
(73) Patentinhaber: PolyIC GmbH & Co. KG, 90763 Fürth (DE)
(72) Erfinder: ULLMANN, Andreas, 90513 Zirndorf (DE); HERBST, Thomas, 92265 Edelsfeld (DE); FIX, Walter, 90763 Fürth (DE); WALTER, Manfred, 90419 Nürnberg (DE)
(74) Vertreter: Louis Pöhlau Lohrentz
(86) Internationale Anmeldenummer: PCT/EP2013/071387
(87) Internationale Veröffentlichungsnummer: WO 2014/060334

(56) Entgegenhaltungen:
- EP-A2- 1 100 043
- US-A1- 2006 082 556

## Beschreibung

Die Erfindung betrifft eine Folie, die zumindest eine elektrische oder eine elektronische Funktionsschicht aufweist. In einem Funktionsbereich der Funktionsschicht ist zumindest ein elektrisches und/oder elektronisches Bauelement bereitgestellt; in einem Kontaktierungsbereich der zumindest einen Funktionsschicht ist zumindest ein elektrischer Anschluss vorgesehen, der galvanisch mit zumindest einem Bauelement gekoppelt ist, nämlich in der Funktionsschicht galvanisch gekoppelt ist, über (Kontakt-) Verbindungen in derselben.

Die Folie weist insbesondere eine Kontaktierungslasche auf, die den Kontaktierungsbereich zumindest zum Teil bereitstellt.

Eine solche Folie kann beispielsweise eine Tastfeldfunktionalität bereitstellen; dann weist sie kapazitive Elemente auf und ist auch als Sensorfolie bezeichenbar. Alternativ (oder zusätzlich) kann die Folie Leuchtdiodenelemente tragen (etwa organische Leuchtdioden).

Derartige Folien können für sich ohne weitere Maßnahme einem Einsatzzweck zugeführt werden. Es ist aber üblich, eine solche Folie in einen Körper zu integrieren, der insbesondere ein Kunststoffteil ist, um die Folie abzustützen und so zu stabilisieren und vor Beschädigung zu schützen. Der Körper kann dann auch in einem Gerät als fertiges Bauteil verwendet werden.

Eine gängige Maßnahme, eine Folie in einen solchen Körper zu integrieren, besteht darin, die Folie zu hinterspritzen. Alternativ ist es auch möglich, die Folie auf einen bereits hergestellten Grundkörper aufzukleben, aufzuklemmen oder aufzulaminieren.

Aus der US 2006/0082556 ist ein ringförmiger potenziometrischer Touchsensor bekannt, der ein Grundsubstrat aufweist, von dem eine Kontaktierunglasche abgeht, auf der die leitfähige Struktur fortgeführt ist.

Aus der EP 1100043 ist ein Touchsensor bekannt, bei dessen Montage ein Tail eingeklemmt und somit befestigt wird.

Entsprechend betrifft die Erfindung auch einen Körper, nämlich ein Kunststoffteil. Bevorzugt ist das Kunststoffteil durch ein In-Mould-Verfahren hergestellt.

Bei einem In-Mould-Verfahren unterscheidet man zwischen dem In-Mould-Labeling (IML) und dem In-Mould-Dekorieren (IMD). Beim In-Mould-Verfahren wird insbesondere eine Folie hinterspritzt. Beim In-Mould-Labeling wird hierbei diese gesamte Folie Teil des fertigen Körpers bzw. Kunststoffteils. Bei der In-Mould-Dekoration verwendet man ein Rolle-zu-Rolle-Verfahren, bei dem ein Folienband durch die Spritzgussform hindurch geführt wird. Das Folienband weist eine Trägerschicht und eine Übertragungslage auf. Die Übertragungslage kann sich von der Trägerschicht lösen. Nach dem Hinterspritzen verbleibt die Übertragungslage an dem fertigen Körper, wohingegen die Trägerschicht abgelöst wird und weiter transportiert wird.

Die Folie wird üblicherweise partiell so hinterspritzt, dass der Kontaktierungsbereich zumindest teilweise von dem spritzgegossenen Kunststoffmaterial frei ist. Die Kontaktierungslasche der Folie wird hierbei nicht oder nur in einem Ansatzbereich hinterspritzt und kann somit wegstehen und zu einem Gegenkontakt geführt werden. Die Kontaktierungslasche muss demgemäß eine gewisse Flexibilität haben. Es muss darauf geachtet werden, dass die Kontaktierungslasche als solche nicht beschädigt wird, und dass auch Kontaktierungsbahnen (Leiterbahnen) auf der Kontaktierungslasche nicht beschädigt werden.

Es ist die Aufgabe der Erfindung, einen Weg aufzuzeigen, wie eine Folie der eingangs genannten Gattung und ein Körper, der insbesondere als Kunststoffteil durch ein In-Mould-Verfahren hergestellt ist, ausgestaltet wird, damit auf besonders zuverlässige Weise vermieden wird, dass beim Kontaktieren Schäden auftreten.

Die Aufgabe wird durch eine Folie mit zumindest einer elektrischen oder elektronischen Funktionsschicht gelöst, wobei in einem Funktionsbereich der Funktionsschicht zumindest ein elektrisches und/oder elektronisches Bauelement bereitgestellt ist, und wobei in einem Kontaktierungsbereich der zumindest einen Funktionsschicht zumindest ein elektrischer Anschluss vorgesehen ist, der (insbesondere über Verbindungen in der Funktionsschicht) galvanisch mit zumindest einem Bauelement gekoppelt ist, und wobei die Folie eine Kontaktierungslasche aufweist, die zumindest einen Teil des Kontaktierungsbereichs bereitstellt, wobei auf der Funktionsschicht in einem Übergangsbereich zwischen dem Funktionsbereich und dem Kontaktierungsbereich, welcher Übergangsbereich zumindest einen Teilbereich der Kontaktierungslasche umfasst, eine weitere Lage in einer Dicke von zumindest 300 nm, bevorzugt zumindest von 1 µm, ganz besonders bevorzugt zumindest von 7 µm, aufgebracht ist und wobei die weitere lage ein elektrisch leitfähiges Material umfasst.

Die Aufgabe wird auch durch einen Körper gelöst, der eine Folie mit zumindest einer elektrischen oder einer elektronischen Funktionsschicht aufweist, wobei in einem Funktionsbereich der Funktionsschicht zumindest ein elektrisches und/oder elektronisches Bauelement bereitgestellt ist, und wobei in einem Kontaktierungsbereich der zumindest einen Funktionsschicht zumindest ein elektrischer Anschluss vorgesehen ist, der (insbesondere über Verbindungen in der Funktionsschicht) galvanisch mit zumindest einem Bauelement gekoppelt ist, wobei der Körper ferner ein Kunststoffhauptmaterial umfasst, mit dem die Folie partiell so verbunden ist, dass der Kontaktierungsbereich zumindest teilweise von Kunststoffhauptmaterial frei ist, so dass eine Kontaktierungslasche wegsteht, wobei auf der Funktionsschicht in einem Übergangsbereich zwischen dem Funktionsbereich und dem Kontaktierungsbereich, der zumindest einen Teilbereich der Kontaktierungslasche umfasst, eine weitere (Material-) Lage in einer Dicke von zumindest 300 nm, bevorzugt zumindest von 1 µm, ganz besonders bevorzugt zumindest von 7 µm, aufgebracht ist wobei die weitere Lage ein elektrisch leitfähiges Material umfasst und der Körper mit einem Kunststoffhauptmaterial partiell so verbunden ist, dass der Kontaktierungsbereich zumindest teilweise von Kunststoffhauptmaterial frei ist, so dass die Kontaktierungslasche wegsteht.

Die vorliegende Erfindung beinhaltet die Idee, durch die weitere Lage die Kontaktierungslasche selbst, als Ganzes, oder die Funktionsschicht dort vor Beschädigung zu schützen. Dies ist insbesondere durch die angegebene Dicke der weiteren Lage gewährleistet; das gilt im besonderen Maße dann, wenn die elektrische oder elektronische Funktionsschicht eine gängige Dicke (von z. B. zwischen 10 und 50 nm) aufweist und/oder wenn ein Substrat, das die elektrische oder elektronische Funktionsschicht trägt, eine entsprechende typische Dicke von einigen Mikrometern aufweist. Nach oben muss der Dicke der weiteren Lage keine Grenze gesetzt werden, sofern die Kontaktierungslasche noch ausreichend flexibel bleibt. In dem Übergangsbereich endet gerade der hinterspritzte Bereich, es beginnt also die Kontaktierungslasche. Durch die weitere Lage ist genau an dieser empfindlichen Stelle dafür gesorgt, dass nicht oder zumindest in einem verringerten Maße Gefahr besteht, dass die Lasche ein- oder abgerissen wird oder die elektrische oder elektronische Funktionsschicht am Übergang von Kunststoffhauptmaterial zu einem von Kunststoffhauptmaterial freien Bereich beschädigt wird, z. B. Kontaktierungsbahnen eingerissen werden.

Bei dem zweiten Aspekt, demgemäß sich die Lasche in einem Übergangsbereich von dem Funktionsbereich weg verjüngt, ist durch die Form der Lasche selber gewährleistet, dass die Lasche nicht so schnell beschädigt wird, wenn sie zum Zwecke des Kontaktierens mit einem Gegenkontakt gebogen wird. Dabei ist insbesondere vorteilhaft, dass sich ihre Breite um zumindest 20%, bevorzugt zumindest 40% einer anfänglichen Breite verringert.

In einer Variante weist die weitere Lage ein elektrisch isolierendes Material auf. Das elektrisch isolierende Material verhindert elektrische Überschläge auf die elektronischen Bauelemente und entsprechende Verbindungsleitungen.

Insbesondere kann als elektrisches Isolierungsmaterial ein geeignetes, etwa zu einem unter der elektrischen bzw. elektronischen Funktionsschicht angeordneten Substrat passendes Kunststoffmaterial ausgewählt werden.

Beispielsweise kann das elektrisch isolierende Material Polymethyl(meth)acrylat (PMMA), Polycarbonat und/oder Acrylnitrilbutadienstyrol (ABS) umfassen und/oder Zinkoxidpartikel enthalten.

Das Material kann in Form eines Lackes auf die elektrische Funktionsschicht als weitere Lage aufgetragen sein, was für einen besonders guten Zusammenhalt sorgt.

Es kann aber auch in Form einer gesonderten Folie bereitgestellt sein, die in einem Herstellungsverfahren besonders leicht aufbringbar ist.

Es kann vorgesehen sein, dass ein Substrat die elektrische oder elektronische Funktionsschicht trägt. In einer Ausführungsform weist dann das elektrische isolierende Material eine um höchstens +/- 10 % von der Dicke des Substrats abweichende Dicke auf. Diese Ausführungsform ist dann geeignet, wenn das elektrisch isolierende Material dasselbe Material ist wie das für das Substrat verwendete Material oder zumindest ein vergleichbares Material ist, insbesondere hinsichtlich seiner Biegeeigenschaften (Elastizitätsmodul). Bei einer zweiten Ausführungsform ist das elektrisch isolierende Material jedoch härter als das Substrat und kann daher dünner als selbiges ausgeführt sein.

Bei einer zweiten Variante hinsichtlich des Aspektes der Bereitstellung der weiteren Lage umfasst selbige ein elektrisch leitfähiges Material. Dessen Einsatz ist insbesondere dazu geeignet, elektrische Verbindungsbahnen (Kontaktbahnen) vor Beschädigung zu schützen und gleichzeitig deren Funktionsweise zu unterstützen.

Das elektrisch leitfähige Material kann insbesondere Leitsilber oder Carbon Black umfassen. Solches Material lässt sich besonders gut aufdrucken.

Neben dem Vorsehen dieses elektrisch leitfähigen Materials in dem Übergangsbereich zwischen dem Funktionsbereich und dem Kontaktierungsbereich kann das elektrisch leitfähige Material insbesondere auch an einem freien Ende der Kontaktierungslasche bereitgestellt sein und den elektrischen Anschluss der Funktionsschicht bedecken. Hierdurch wird der elektrische Anschluss über die Schichtdicke der Funktionsschicht hinaus gerade an dem Anschlussende verstärkt, so dass beim Anschließen an einen Gegenkontakt wirkungsvoll eine mögliche Beschädigung vermieden wird.

Als Zusatzmaßnahme zur Verstärkung des freien Endes der Lasche auf der Seite der elektrischen bzw. elektronischen Funktionsschicht kann ein Versteifungselement an der der Funktionsschicht abgewandten Seite der Folie vorgesehen sein; ein solches Verstärkungselement kann ein sicheres Anschließen des Kontaktbereiches per Kontaktierungslasche an einen Gegenkontakt ermöglichen. Das Verstärkungselement kann aus Polyethylenterephtalat, Polypropylen, Polycarbonat oder Polyethylennaphtalat bestehen und hierbei eine solche Foliendicke aufweisen, dass die Gesamtdicke aus der übrigen Folie mit dem Verstärkungselement im Bereich von 150 bis 600 µm liegt, z. B. 300 µm beträgt. Das die weitere Lage zumindest zum Teil bildende elektrisch leitfähige Material kann eine Dicke aus dem Intervall von 1 bis 15 µm aufweisen, vorzugsweise 2 bis 5 µm.

Die beiden Varianten der Verwendung von elektrisch isolierendem Material und elektrisch leitfähigem Material für die weitere Lage schließen sich nicht gegenseitig aus: So kann elektrisch leitfähiges Material auf der elektrischen Funktionsschicht bereitgestellt sein, insbesondere nur bereichsweise, und elektrisch isolierendes Material das elektrisch leitfähige Material in dem Übergangsbereich bedecken, an dem freien Ende der Kontaktierungslasche aber elektrisch leitfähiges Material freilassen. Bei dieser Ausführungsform wird die positive Eigenschaft des elektrisch isolierenden Materials einer besonders guten Flexibilität bei großer Lagendicke verbunden mit dem Vorteil, dass das elektrisch leitfähige Material die elektrische Funktionsschicht verstärkt, insbesondere an dem freien Ende vor Abrieb schützt.

Die elektrische bzw. elektronische Funktionsschicht kann auch solche leitfähigen Bahnen aus Metall, insbesondere den genannten Materialien umfassen, die mindestens 100 µm breit sind. Solche Bahnen sind an sich gut sichtbar, können aber durch ein Kunststoffmaterial, etwa in einer gesonderten Dekorlage oder durch das Substrat, verdeckt werden.

In einer anderen Ausführungsform weist die elektrische Funktionsschicht organische Leiter wie PAni (Polyanilin) oder PEDOT/PSS (Poly-3.4-Ethylendioxythiophen-Polystyrolsulfonat) auf. Außerdem kann die elektrische bzw. elektronische Funktionsschicht Metall-Nanodrähte (z. B. aus Silber, Kupfer oder Kohlenstoff-Nanoröhrchen, Kohlenstoff-Nanopartikeln oder Graphen umfassen). Ferner können Kombinationen der genannten Materialien in der Funktionsschicht vorgesehen sein.

Üblicherweise umfasst die Folie ein bereits erwähntes Substrat, welches die weiteren Schichten und insbesondere die Funktionsschicht trägt. Dieses Substrat besteht aus Kunststoff, wobei sich insbesondere Polyethylenterephtalat, Polypropylen, Polycarbonat, Polyethylennaphtalat eignen, vorzugsweise in einer Dicke aus dem Intervall von 12 bis 150 µm, besonders bevorzugt aus dem Intervall von 35 bis 60 µm.

Das Substrat ist in einer Variante zwischen der Funktionsschicht und dem Kunststoffhauptmaterial angeordnet. In diesem Falle liegt die weitere Lage auf der dem Kunststoffhauptmaterial abgewandten Seite des Substrats auf der Funktionsschicht.

In einer anderen Variante ist die Funktionsschicht zwischen dem Substrat und dem Kunststoffhauptmaterial angeordnet, weist also zu dem Spritzgussmaterial hin. In diesem Fall ist auch die weitere Lage zwischen dem Substrat und dem Kunststoffhauptmaterial angeordnet, weil sie ja auf der Funktionsschicht angeordnet ist.

Bei dem zweiten Aspekt der Erfindung mit der sich verjüngenden Kontaktierungslasche weist bevorzugt die Funktionsschicht in dem Kontaktierungsbereich zu zumindest einem Anschluss eine solche Kontaktbahn (Verbindungsleitung) auf, die sich zu dem Übergangsbereich hin verbreitert. Dadurch, dass die Kontaktbahn im Übergangsbereich breiter ist als sonst, kann bei einer Biegebewegung bezüglich der Kontaktierungslasche vermieden werden, dass die Kontaktbahn als Ganzes unterbrochen wird.

Als Kunststoffhauptmaterial, das spritzgegossen wird, eignet sich prinzipiell jeder thermoplastische Kunststoff, bevorzugt sind Acrylnitrilbutadienstyrol (ABS), Polycarbonat oder Polyamid.

Ein solches Kunststoffmaterial kann gefärbt sein, damit man nicht in das Innere eines Gehäuses blicken kann, das von dem Körper begrenzt ist. Bei einer anderen bevorzugten Variante ist hingegen das Kunststoffhauptmaterial transparent und ermöglicht somit ein Hindurchschauen durch den Körper. Dies ist insbesondere dann möglich, wenn auch die elektrische bzw. elektronische Funktionsschicht der Folie an dem Körper transparent wirkt. Dieser Effekt ist beispielsweise durch die Maßnahme erzielbar, dass die elektrische bzw. elektronische Funktionsschicht eine Vielzahl von leitfähigen Bahnen (Leiterbahnen) aufweist, welche aus Metall, insbesondere aus Silber, Kupfer, Aluminium, Chrom oder aus einer Metalllegierung bestehen, und die eine Breite von zwischen 1 µm und 40 µm aufweisen (bevorzugt zwischen 5 µm und 25 µm), und die gleichzeitig einen Abstand von 10 µm bis 5 mm zueinander haben (bevorzugt liegt er zwischen 300 µm und 1 mm). Solche Leiterbahnen sind für das menschliche Auge nicht bzw. schwer auflösbar und können daher nicht einzeln erkannt werden. Die Transparenz der elektrischen Funktionsschicht beträgt mindestens 70 %, bevorzugt mindestens 80 % trotz der metallischen Leiterbahnen. Diese Leiterbahnen sind bevorzugt in einer Schichtdicke aus dem Intervall von 10 bis 150 nm, bevorzugt aus dem Intervall von 30 bis 60 nm bereitgestellt.

Der Körper ist bei einer bevorzugten Ausführungsform auf eine solche Weise bereitgestellt, dass die Folie mit dem Kunststoffmaterial hinterspritzt ist; die genannte Verbindung der Folie mit dem Kunststoffhauptmaterial erfolgt also automatisch beim Vorgang des Hinterspritzens. Alternativ oder zusätzlich kann das Kunststoffhauptmaterial (bereichsweise) angeklebt und/oder (bereichsweise) angeklemmt und/oder auf das Kunststoffmaterial auflaminiert sein.

Bei dem Körper kann zum Erleichtern des Spritzgießens eine Haftvermittlerschicht zumindest an dem mit Kunststoff hinterspritzten Teil der Folie vorgesehen sein. Auf diese Weise wird für einen besonders guten Verbund der Komponenten Kunststoffhauptmaterial und Folie gesorgt.

Nachfolgend werden bevorzugte Ausführungsformen der Erfindung unter Bezug auf die Zeichen näher erläutert, in der
- Fig. 1a: eine perspektivische Ansicht, und
- Fig. 1b: eine Draufsicht eines Kunststoffteils als Körper nach dem Stand der Technik veranschaulicht,

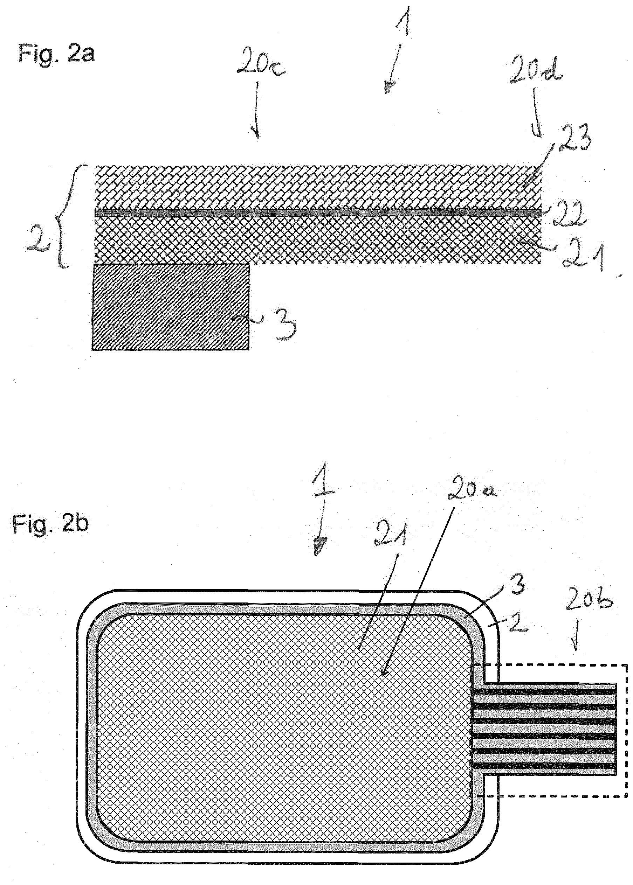

- Fig. 2a, 2b: eine erste Ausführungsform der Erfindung veranschaulichen, wobei Fig. 2b eine Draufsicht ist, und wobei Fig. 2a einen Schnitt in dem in Fig. 2b strichliert umrandeten Bereich darstellt,
- Fig. 3a, 3b: eine zweite Ausführungsform der Erfindung veranschaulichen, wobei ebenfalls Fig. 3a einen Schnitt darstellt und Fig. 3b eine Draufsicht,
- Fig. 4a, 4b: eine dritte Ausführungsform der Erfindung veranschaulichen, wobei Fig. 4a auch hier einen Schnitt darstellt und Fig. 4b eine Draufsicht, wobei ferner
- Fig. 4c: einen Schnitt einer ersten Variante der dritten Ausführungsform gemäß Fig. 4a veranschaulicht, und
- Fig. 4d, 4e: einen Schnitt bzw. eine Draufsicht einer zweiten Variante der dritten Ausführungsform gemäß Fig. 4a veranschaulichen,
- Fig. 5a: eine vierte Ausführungsform der Erfindung in einem der Fig. 4a entsprechenden Schnitt veranschaulicht und
- Fig. 5b: eine Erweiterung der Ausführungsform nach Fig. 5a veranschaulicht,
- Fig. 6a, 6b: eine fünfte Ausführungsform der Erfindung veranschaulichen, wobei Fig. 6a einen Schnitt darstellt und Fig. 6b eine Draufsicht,
- Fig. 6c: einen Schnitt einer Variante der sechsten Ausführungsform der Erfindung veranschaulicht,
- Fig. 7a, 7b: eine Draufsicht auf eine sechste Ausführungsform der Erfindung darstellen, wobei Fig. 7b den in Fig. 7a rechten Teilausschnitt vergrößert zeigt, und
- Fig. 8: einen Schnitt einer Abwandlung des Körpers der Fig. 1 - 7b zeigt.

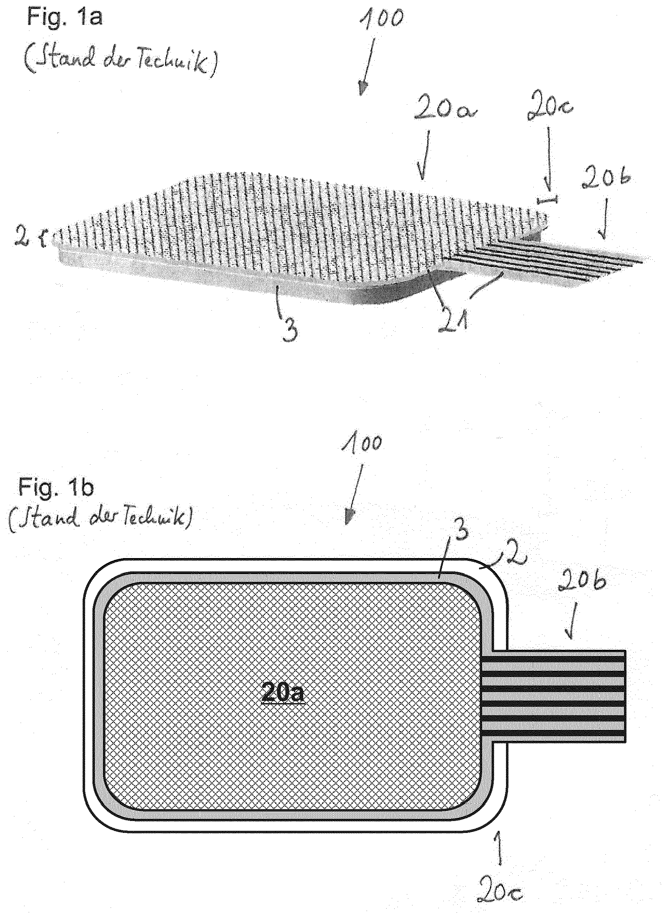

Ein in den Figuren 1 a und 1 b gezeigter und im Ganzen mit 100 bezeichneter Körper umfasst eine Folie 2 und Spritzgussmaterial 3. Die Schichtdicken der einzelnen Komponenten sind nicht maßstäblich gezeichnet. Die Folie 2 bildet ein Folienelement, das ein Substrat 21 umfasst, welches über eine in der Figur nicht gezeigte Haftvermittlerschicht (auch als "Primer" bezeichnet) an dem Spritzgussmaterial 3 anhaftet. Es ist nicht die gesamte Folie 2 hinterspritzt, sondern lediglich ein erster Bereich 20a der Folie 2, wohingegen ein zweiter Bereich 20b der Folie 2 nicht hinterspritzt ist. Der erste Bereich 20a ist insbesondere ein Funktionsbereich und der zweite Bereich 20b ein Kontaktierungsbereich. In einem Übergangsbereich 20c steht die Folie 2 über das Spritzgussmaterial 3 hinaus.

Vorliegend soll die Folie eine elektrische Funktionsschicht 22 auf dem Substrat 21 umfassen, beispielsweise in Form von kapazitiven Elementen zur Bereitstellung einer Tastfeldfunktionalität (so dass die Folie 2 eine Sensorfolie ist). Alternativ oder zusätzlich ist es möglich, dass die Folie 2 Leuchtdiodenelemente trägt, z.B. organische Leuchtdioden ("OLED").

Die elektrische Funktionsschicht 22 wird vorliegend bevorzugt in Form einer Metallschicht bereitgestellt, welche Silber, Kupfer, Aluminium, Chrom oder andere Metalle oder Metallverbindungen und -legierungen umfasst. Die Schichtdicke dieser Metallschicht beträgt zwischen 10 und 150 nm, typischerweise zwischen 30 und 60 nm. Die Metallschicht ist insbesondere nicht durchgängig, sondern umfasst metallische Leiterbahnen in einem entweder besonders regelmäßigen oder gerade unregelmäßigen Muster, wobei die Leiterbahnen jeweils eine Breite von zwischen 1 µm und 40 µm aufweisen, bevorzugt etwa 5 µm und 20 µm, und einen Abstand von zwischen 100 µm und 5 mm zueinander haben, bevorzugt von zwischen 300 µm und 1 mm. Solche metallischen Leiterbahnen sind mit dem menschlichen Auge ohne Hilfsmittel nicht erkennbar. Dadurch wirkt die elektrische Funktionsschicht 22 transparent, obwohl elektrische Bauelemente zumindest in Form von elektrischen Widerstandselementen und dergleichen bereitgestellt sind. Etwa bei einer Tastfeldfunktionalität sind die einzelnen Tastfelder durch elektrische Leiterbahnen gebildet, welche galvanisch miteinander gekoppelt sind. Die kapazitive Koppelung erfolgt zu anderen Tastfeldern, die nicht galvanisch mit diesen Leiterbahnen gekoppelt sind und ihrerseits eine Mehrzahl von metallischen Leiterbahnen aufweisen, die untereinander galvanisch miteinander gekoppelt sind.

Die Erfindung ist nicht auf die Verwendung von metallischen Leiterbahnen zur Bereitstellung einer Tastfeldfunktion eingeschränkt. Jegliche leitenden und halbleitenden Elemente können zur Bereitstellung elektrischer und elektronischer Bauelemente beitragen. Beispielsweise kann Metall in Form von Nanodrähten (etwa aus Silber, Kupfer oder Gold) oder Nanopartikeln (etwa aus Silber, Gold oder Kupfer) bereitgestellt sein, es können Kohlenstoff-Nanoröhrchen oder Kunststoff-Nanopartikeln bereitgestellt sein, und schließlich können auch Elemente aus Graphen vorgesehen sein. Außerdem können organische Leiter aus PEDOT/PSS (Poly-3.4-Ethylendioxythiophen-Polystyrolsulfonat) oder aus PAni (Polyanilin) bereitgestellt sein. Insbesondere können aktive elektrische Bauteile wie beispielsweise organische Leuchtdioden, anorganische oder organische Photovoltaikzellen, andere Displayelemente wie etwa aus Elektrolumineszenzmaterialien, elektrochromen Materialien oder elektrophoretischen Materialien vorgesehen sein, es können integrierte Schaltungen oder anorganische oder organische Speicher vorgesehen sein. All dies kann im Rahmen der vorliegenden Erfindung gleichermaßen eingesetzt werden. Das gilt für alle in dieser Anmeldung beschriebenen Schicht- bzw. Lagenaufbauten und -abfolgen.

Der Kontaktierungsbereich 20b, der die Form einer von dem Funktionsbereich 20a wegragenden Kontaktierungslasche hat, umfasst einen elektrischen Anschluss für die Elemente in der elektrischen Funktionsschicht.

Durch das Abstehen der Kontaktierungslasche besteht die Gefahr, dass diese im Übergangsbereich zwischen dem Spritzgussmaterial 3 zum freien Raum einreißt, oder dass dort die elektrische Funktionsschicht beschädigt wird. Die Kontaktierungslasche dient zum Anschließen der Elemente in dem Funktionsbereich 20a über einen Gegenkontakt. Es soll auch vermieden werden, dass beim Kontaktieren an einen Gegenkontakt die elektrische Funktionsschicht am freien Ende der Kontaktierungslasche beschädigt wird.
Nachfolgend werden einige Maßnahmen aufgezeigt, wie solche Beschädigungen verhindert werden können.

Bei der ersten Ausführungsform des erfindungsgemäßen Körpers 1 ist auf die elektrische Funktionsschicht 22 elektrisch leitfähiges Material als Lage 23 aufgebracht. Das elektrisch leitfähige Material wird genau dort aufgebracht, wo sich auch als Teil der elektrischen Funktionsschicht 22 bereits elektrisch leitfähiges Material befindet.

Das Material kann durch Aufbringen einer elektrischen leitfähigen Paste auf die Folie 2 bereitgestellt sein und Leitsilber und/oder Carbon Black umfassen bzw. sein. Das Aufbringen der Lage 23 erfolgt über den gesamten Bereich, in dem die elektrische Funktionsschicht 22 vorhanden ist. Durch ein solches Aufbringen der Lage 23 wird sowohl der Übergangsbereich 20c als auch das freie Ende 20d der Kontaktierungslasche geschützt. Voraussetzung ist, dass die Schichtdicke ausreichend groß ist, insbesondere zwischen 1 µm und 25 µm liegt, bevorzugt zwischen 6 und 10 µm liegt, z. B. 8 µm beträgt.

Bei einer zweiten Ausführungsform des erfindungsgemäßen Körpers 1' ist das elektrisch leitfähige Material, also insbesondere die elektrisch leitfähige Paste, nicht vollflächig aufgebracht, sondern lediglich im Übergangsbereich 20c zwischen dem Funktionsbereich 20a und dem Kontaktierungsbereich 20b (Bezugszeichen 23a) und ist außerdem am freien Ende 20d vorgesehen (siehe das Bezugszeichen 23b). Im Übergangsbereich 20c besteht ein Schutz beim Biegen der Kontaktierungslasche, wo hingegen im Endbereich 20d die elektrischen Anschlüsse vor einem Beschädigtwerden beim Kontaktieren mit einem Gegenkontakt geschützt sind. Hierbei ist insbesondere in jedem Bereich, in dem das elektrisch leitfähige Material überhaupt aufgebracht ist (also im Übergangsbereich 20c und am freien Ende 20d) die Aufbringung dergestalt, dass nur dort das elektrisch leitfähige Material (also die elektrisch leitfähige Paste) aufgebracht wird, wo auch schon die elektrische Funktionsschicht elektrisch leitfähige Bereiche umfasst.

Bei einer dritten Ausführungsform des erfindungsgemäßen Körpers 1" ist auf der elektrischen Funktionsschicht 22 ein elektrisch isolierendes Material in Form einer gesonderten Lackschicht 24 oder auch einer aufgebrachten Folie vorgesehen. Das elektrisch isolierende Material erstreckt sich jedoch gerade nicht bis zum freien Ende 20d hin, sondern erfasst lediglich den Übergangsbereich 20c. Damit schützt das elektrisch isolierende Material, das aus demselben Material bestehen kann wie das Substrat 21 (mögliche Materialien s. u.). Es ist bei der Ausführungsform gemäß Fig. 1a im Wesentlichen in derselben Schichtendicke vorgesehen wie das Substrat 21 und hält daher die Kontaktierungslasche noch flexibel, vermeidet aber gleichzeitig eine Beschädigung derselben oder der elektrischen Funktionsschicht 22 im Übergangsbereich 20c.

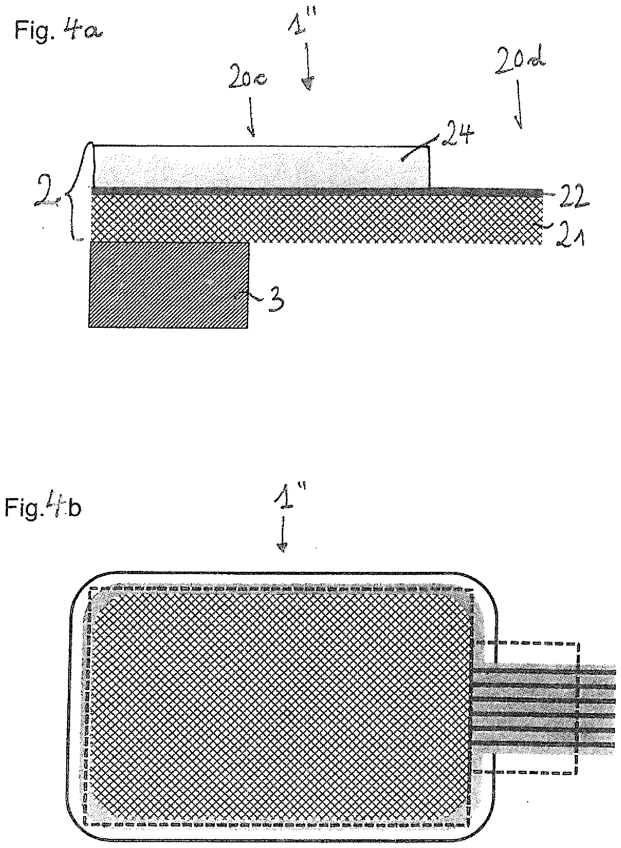

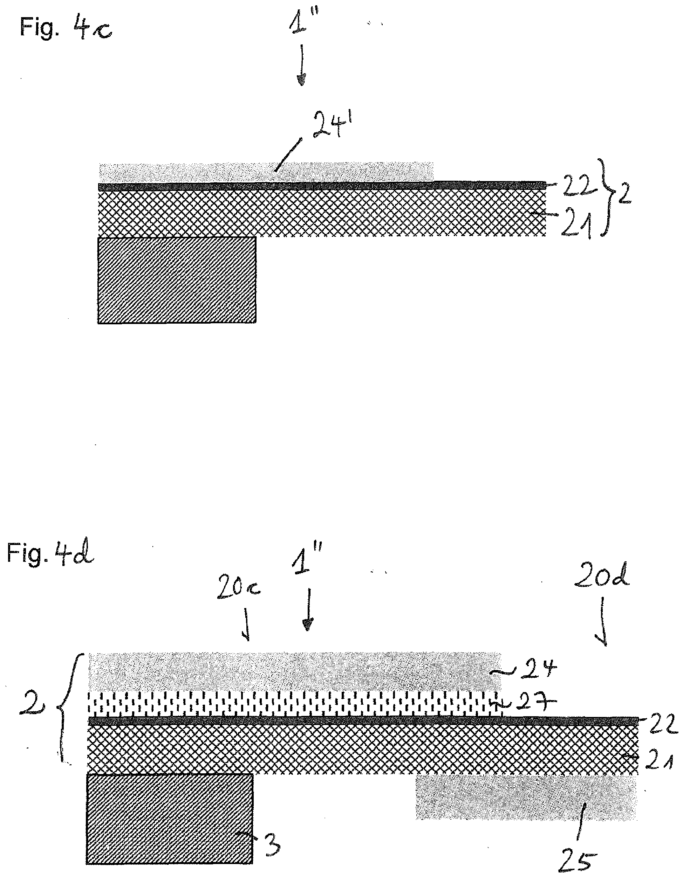

Bei einer Variante gemäß Fig. 4c ist die elektrisch isolierende Lage 24' aus einem härteren Material ausgebildet als das Substrat 21 und dafür dünner als selbiges vorgesehen.

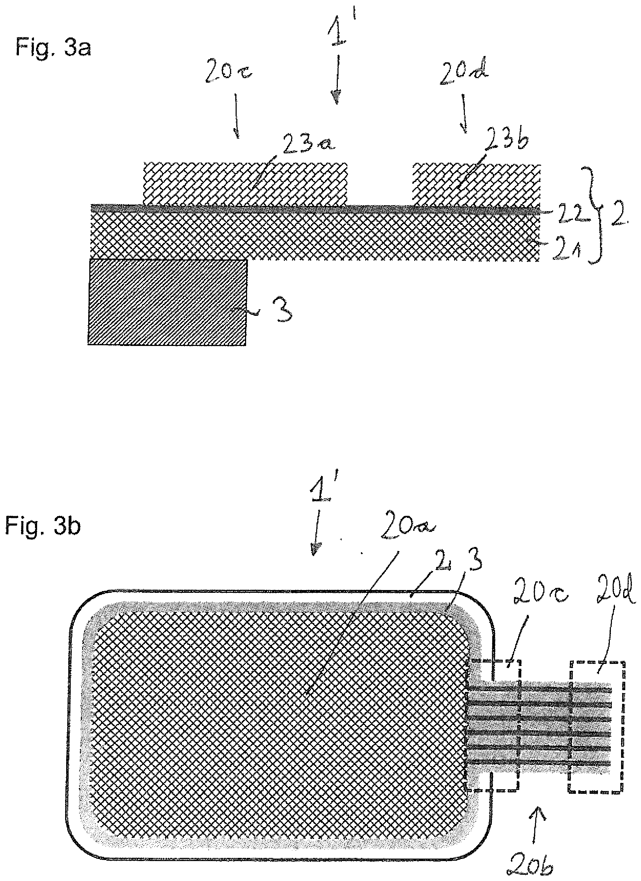

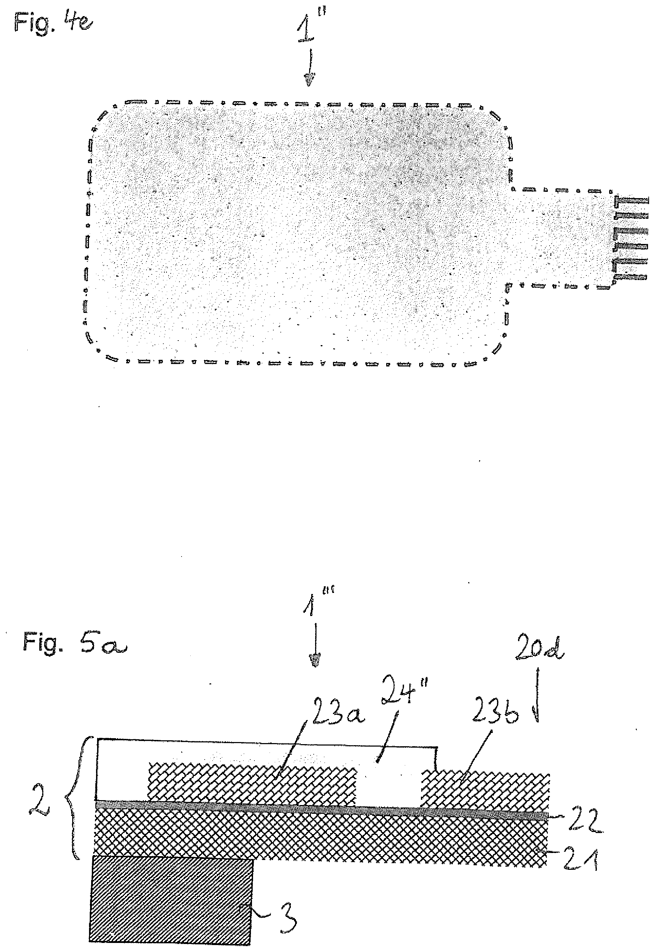

Bei einer Variante gemäß Fig. 4d/e ist die elektrisch isolierende Lage 24 in Form einer Folie bereitgestellt, die über eine gesonderte Kleberschicht 27 an der elektrischen Funktionsschicht 22 befestigt ist. Ferner befindet sich am freien Ende 20d ein Versteifungselement 25. Dieses erstreckt sich bis in den Bereich unterhalb der Folie 24 und der Kleberschicht 27. Besonders bevorzugt ist es bei dieser Variante, wenn am freien Ende 20d auch noch zusätzlich das leitfähige Material, insbesondere Carbon Black, in dem Abschnitt 23b wie in Fig. 3a gezeigt, vorgesehen ist.
Die Ausführungsformen gemäß Fig. 3a/b einerseits und Fig.4a bis c andererseits lassen sich zu einer Ausführungsform des erfindungsgemäßen Körpers 1'" miteinander kombinieren: Es kann sowohl leitfähiges Material wie in Fig. 3a gezeigt in den entsprechenden Bereichen als Abschnitte 23a und 23b vorgesehen sein, und der Abschnitt 23a, möglicherweise teilweise der Abschnitt 23 b, wird durch elektrisch isolierendes Material 24" bedeckt, wobei aber das freie Ende 20d freigelassen ist, damit eine elektrische Kontaktierung im Bereich des freien Endes 20d erfolgen kann.

Wie aus Fig. 4e ersichtlich, sind die Klebeschicht 27 und die Folie 24 so gut wie vollflächig auf das Substrat 21 und die Funktionsschicht 22 aufgebracht, vergleiche insbesondere den gestrichelten umrahmten Bereich in Fig. 4e; lediglich das freie Ende 20d bleibt für die elektrische Kontaktierung unbedeckt.

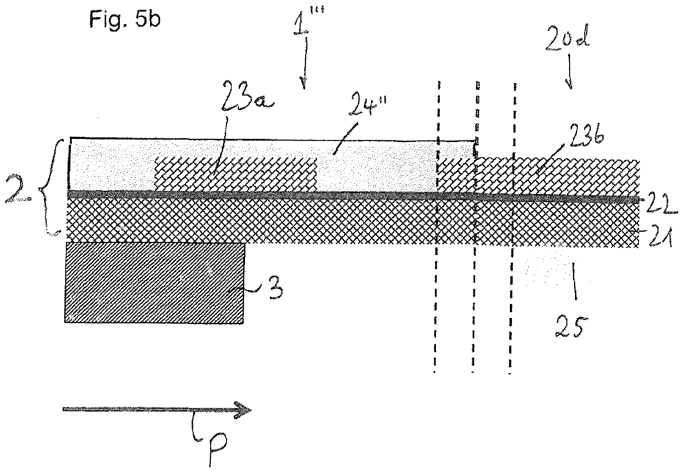

Zusätzlich kann noch, wie in Fig. 5b gezeigt, am freien Ende 20d ein Versteifungselement 25 auf der der elektrischen Funktionsschicht 22 abgewandten Seite des Substrats 21 angebracht sein. Wie durch die strichlierten Linien dargestellt, beginnt in Richtung von dem Spritzgussmaterial 3 weg (vergleiche den Pfeil P) zunächst der Abschnitt 23b in der Lage mit der elektrisch leitfähigen Paste, dann endet das Vorsehen des elektrisch isolierenden Materials 24", und dann beginnt das Verstärkungselement 25.

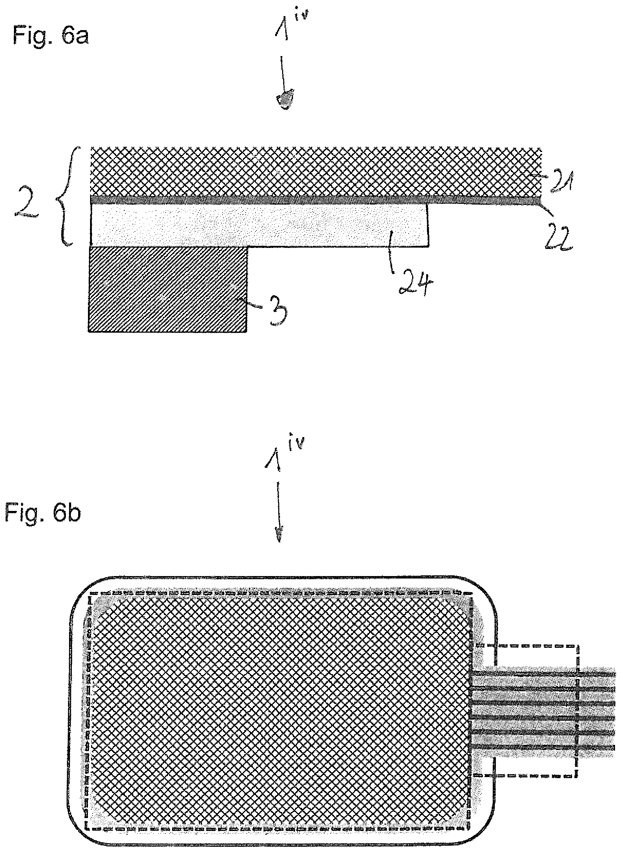

Bei einer fünften Ausführungsform des erfindungsgemäßen Körpers 1^{iv} gemäß Fig. 6a/b weist die elektrische Funktionsschicht 22 zu dem Spritzgussmaterial 3 hin. Da elektrisch isolierendes Material 24 auf der Funktionsschicht 22 aufgebracht ist, weist auch diese elektrisch isolierende Lage 24 zum Kunststoffmaterial 3 hin. Somit ist es nicht das Substrat 21, das an dem Kunststoffmaterial 3 haftet, sondern das elektrisch isolierende Material 24.

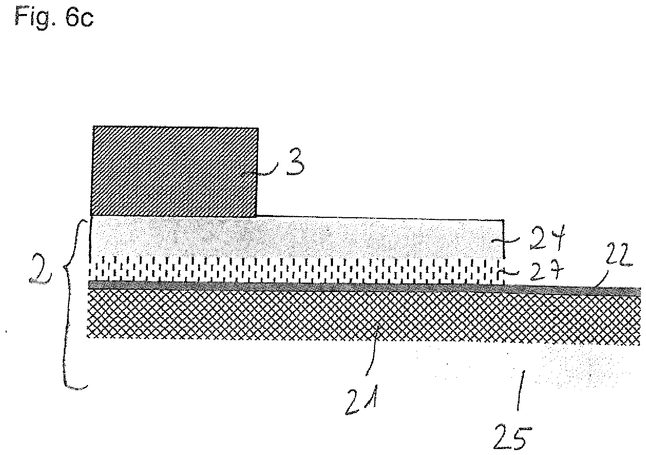

Bei einer Variante dieser Ausführungsform gemäß Fig. 6c liegt das elektrisch isolierende Material 24 in Form einer Folie vor, die über die Kleberschicht 27 auf der Funktionsschicht 22 aufgebracht ist, wie oben anhand der Fig. 4d/e erläutert.

Besonders bevorzugt ist es bei dieser Variante, wenn am freien Ende 20d auch noch zusätzlich das leitfähige Material, insbesondere Carbon Black, in dem Abschnitt 23b wie in Fig. 3a gezeigt, vorgesehen ist.

Grundsätzlich wäre auch bei den beiden Varianten der fünften Ausführungsform gemäß Fig. 6a/6b und 6c das Vorsehen von elektrisch leitfähiger Paste auf der elektrischen Funktionsschicht 22 möglich, die dann ebenfalls zum Kunststoffmaterial 3 zeigen würde.

In den Ausführungsformen gemäß der Fig. 6a/6b und 6c kann insbesondere auch noch eine zusätzliche haftvermittelnde Schicht, insbesondere eine sogenannte Primer-Schicht oder eine Klebeschicht, zwischen dem Kunststoffmaterial 3 und dem isolierenden Material 24 vorgesehen sein. Alternativ kann auch die Schicht mit dem isolierenden Material 24 selbst haftvermittelnde Eigenschaften aufweisen.

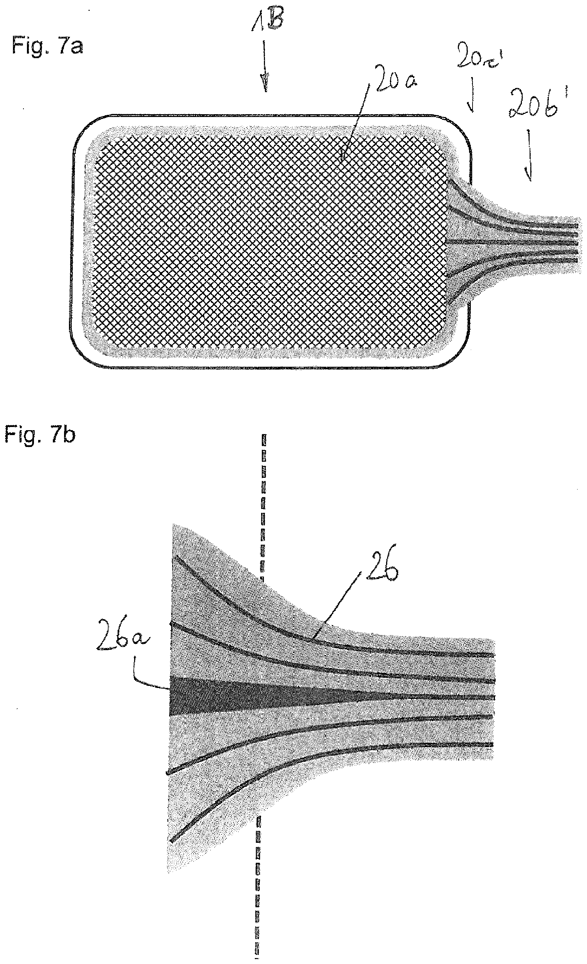

Eine sechste Ausführungsform des erfindungsgemäßen Körpers 1 B zeigt die Fig. 7a mit der Fig. 7b:
Der Kontaktierungsbereich 20b' steht von dem Funktionsbereich 20a so weg wie im Stand der Technik gemäß Fig. 1a/1b, es ist allerdings statt einer im Wesentlichen rechteckigen Lasche wie im Stand der Technik ein Sich-Verjüngen im Kontaktierungsbereich 20b' vorgesehen. Wie sich aus der Fig. 7a und insbesondere auch der Vergrößerung gemäß Fig. 7b ergibt, werden hier rechtwinklige Ecken als potentielle Einrißstellen wirksam vermieden. Elektrische Kontaktbahnen 26 verbreitern sich ebenfalls zumindest teilweise zum Funktionsbereich 20a hin, siehe insbesondere die mittige Kontaktierungsbahn 26a in Fig. 7b.

Nach der Darstellung der unterschiedlichen Ausführungsformen für einen erfindungsgemäßen Körper folgen nun einige Detailangaben, insbesondere einiger wichtiger Werte.

Das Substrat 21 besteht bevorzugt aus Kunststoff, beispielsweise Polyethylenterephtalat, Polypropylen, Polycarbonat, Polyethylennaphtalat, Polyamid and ähnlichen Materialien, wobei das Substrat 21 eine Schichtdicke von 12 bis 600 µm, insbesondere von 12 bis 150 µm, typischerweise von 35 bis 60 µm aufweist.

Das elektrisch isolierende Material 24 kann aus denselben Materialien bestehen, wobei in einem Körper das Substrat 21 als erstes Material ausgebildet sein kann und für das elektrisch isolierende Material 24 ein anderes Material aus den oben genannten ausgewählt sein kann.

Es kann auf der elektrischen Funktionsschicht 22 oder den weiteren Lagen 23, 23a, 23b, 24, 24' auch eine in den Figuren nicht gezeigte Schutzschicht vorgesehen sein, die beispielsweise aus Polyacrylat, Polyvinylchlorid, Polyvinylacetat, Polyurethan, Polycarbonat, Polyester, einem Ethylenvinylacetatcopolymer, einem Kohlenwasserstoffharz, chloriertem Polyolefin, Polyvinylalkohol, Melaminharz, Keton; Formaldehydharz, Polyvinylidenfluorid, Epoxitharz, Polystyrol, einer polymeren Zelluloseverbindung, Phenolharz, Polyamid, polymeren Flüssigkristallen (LCP), Harnstoffharz und Kunstharz bestehen kann oder diese Materialien umfassen kann, oder aus Kombinationen dieser Stoffe bestehen kann oder diese umfassen kann. Dies schließt sowohl thermische als auch strahlengehärtete Lacksysteme ein.

Die Schichtdicke der Schutzschicht kann zwischen 2 und 6 µm liegen. Auch die Schutzschicht trägt in diesem Falle dazu bei, eine Beschädigung der Kontaktierungslasche bzw. der elektrischen Funktionsschicht zu vermeiden.

Das in der Figur nicht gezeigte Haftvermittlermaterial (Primer) kann eine Schichtdicke von zwischen 1 und 9 µm, vorzugsweise von zwischen 1 und 5 µm haben. Es besteht vorzugsweise aus folgendem Material:

| Komponente | Anteil (%) |
|---|---|
| Methylethylketon | 60 |
| Butylacetat | 15 |
| MMA Polymer (Tg: 100°C) | 07 |
| MMA/EA-Copolymer (Tg: 35°C) | 13 |
| Silikat (SiO2) | 05 |

Hierbei ist Tg die Glastemperatur (Einfriertemperatur) der jeweiligen Komponente.

Als Spritzgussmaterial 3 können sämtliche thermoplastische Kunststoffe eingesetzt werden, bevorzugt sind dies Polymethyl(meth)acrylat, Acrylnitrilbutadienstyrol, Polycarbonat oder Polyamid.

Das Spritzgussmaterial kann farbig oder transparent sein. Es kann Füllstoffe wie Glasfasern oder Karbonfasern umfassen, oder auch ohne Füllstoffe vorgesehen sein.

Auch die Folie 2 kann farbig oder transparent sein, wobei auch nur Bereiche farbig und die anderen transparent sein können, z. B. kann der Funktionsbereich 20a farbig sein und die Kontaktierungslasche im Kontaktierungsbereich 20b transparent, und umgekehrt. Auch die Lagen 23 bzw. 24 können ganz oder bereichsweise farbig oder ganz oder bereichsweise transparent sein.

Bei den bisher beschriebenen Ausführungsformen befindet sich unterhalb des Übergangsbereichs 20c zwischen dem Funktionsbereich 20a und dem Kontaktierungsbereich 20b immer eine Kante, weil dort das Kunststoffmaterial 3 endet.

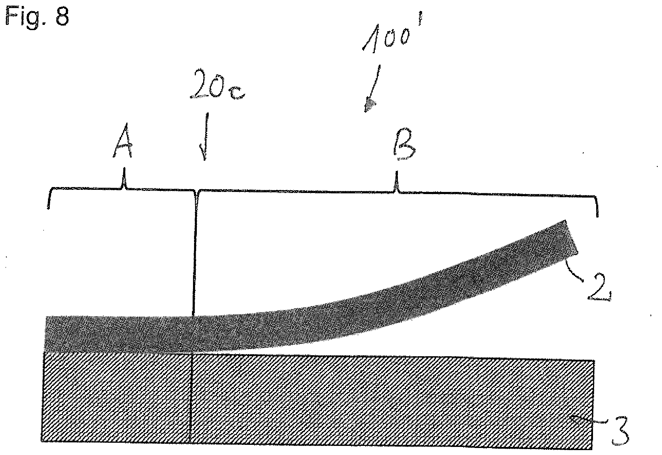

Ein Hinterspritzen kann jedoch auch so erfolgen, dass sich unterhalb der Kontaktierungslasche noch Kunststoffmaterial befindet, wie in Fig. 8 angedeutet: In diesem Falle steht die Kontaktierungslasche zwar weg, sie könnte aber grundsätzlich auf das Kunststoffmaterial 3 aufgelegt werden. Dadurch können Vorteile beim Kontaktieren erzielt werden, etwa wenn das Kunststoffmaterial 3 in einem Gerät fest montiert werden soll und die Kontaktierungslasche 2 innerhalb des Geräts zu einem Gegenkontakt geführt werden soll.

## Patentansprüche

1. Folie (2) mit zumindest einer elektrischen oder elektronischen Funktionsschicht (22), wobei in einem Funktionsbereich (20a, 20a') der Funktionsschicht (22) zumindest ein elektrisches und/oder elektronisches Bauelement bereitgestellt ist, und wobei in einem Kontaktierungsbereich (20b, 20b') der zumindest einen Funktionsschicht (22) zumindest ein elektrischer Anschluss vorgesehen ist, welcher galvanisch mit zumindest einem Bauelement gekoppelt ist und wobei die Folie (2) eine Kontaktierungslasche aufweist, die zumindest einen Teil des Kontaktierungsbereichs (20b, 20b') bereitstellt, wobei auf der Funktionsschicht (22) in einem Übergangsbereich (20c) zwischen dem Funktionsbereich (20a) und dem Kontaktierungsbereich (20b), der zumindest einen Teilbereich der Kontaktierungslasche umfasst, eine weitere Lage (23; 23a, 23b; 24; 24', 24") in einer Dicke von zumindest 300 nm und bevorzugt zumindest 1 µm, besonders bevorzugt von zumindest 7 µm aufgebracht ist, wobei die weitere Lage ein elektrisch leitfähiges Material (23; 23; 23b) umfasst.

2. Folie (2) nach Anspruch 1,
bei der die weitere Lage ein elektrisch isolierendes Material (24, 24', 24") umfasst, welches insbesondere
Polymethyl(meth)acrylat, Polycarbonat und/oder Acrylnitrilbutadienstyrol umfasst und/oder Zinkoxidpartikel enthält.

3. Folie (2) nach Anspruch 2,
bei der das elektrisch isolierende Material (24, 24', 24") in Form eines Lacks bereitgestellt ist oder
in Form einer gesonderten Folie (24, 24'), welche insbesondere vermittels einer Klebstoffschicht (27) an der Funktionsschicht befestigt ist, bereitgestellt ist.

4. Folie (2), nach einem der Ansprüche 2 oder 3,
bei der ein Substrat (21) die elektrische oder elektronische Funktionsschicht (22) trägt und das elektrisch isolierende Material (24) eine um höchstens +/-10 % von der Dicke des Substrats (21) abweichende Dicke aufweist, oder härter und dünner als das Substrat (21) ist.

5. Folie (2), nach einem der vorhergehenden Ansprüche,
bei der die Kontaktierungslasche sich in einem Übergangsbereich von dem Funktionsbereich weg verjüngt, sich ihre Breite insbesondere um zumindest 20 %, bevorzugt zumindest 40 % einer anfänglichen Breite verringert.

6. Folie (2) nach einem der vorhergehenden Ansprüche,
bei der das elektrisch leitfähige Material (23; 23a, 23b) Leitsilber oder Carbon Black umfasst.

7. Folie (2) nach einem der vorhergehenden Ansprüche,
bei dem elektrisch leitfähiges Material (23; 23b) an einem freien Ende (20d) der Kontaktierungslasche bereitgestellt ist und den elektrischen Anschluss der Funktionsschicht (22) bedeckt.

8. Folie (2) nach Anspruch 7,
mit einem Versteifungselement (25) an der der Funktionsschicht (22) abgewandten Seite der Folie (2), welches insbesondere Polyethylenterephtalat, Polypropylen, Polycarbonat oder Polyethylennaphtalat umfasst.

9. Folie (2) nach Anspruch 7 oder 8 in dessen unmittelbarem oder mittelbarem Rückbezug auf Anspruch 2,
bei der das elektrisch leitfähige Material (23a, 23b) auf der elektrischen Funktionsschicht (22) bereitgestellt ist, insbesondere nur bereichsweise, und das elektrische isolierende Material (24") das elektrisch leitfähige Material (23a) in dem Übergangsbereich (20c) bedeckt, aber elektrisch leitfähiges Material (23b) an dem freien Ende (20d) freilässt.

10. Folie (2) nach einem der vorhergehenden Ansprüche,
bei der die Funktionsschicht (22) eine Vielzahl von Leiterbahnen aufweist, welche aus Metall, insbesondere aus Silber, Kupfer, Aluminium, Chrom oder aus einer Metalllegierung bestehen, und die eine Breite von zwischen 1 µm und 40 µm aufweisen und einen Abstand von zwischen 10 µm und 5 mm zueinander haben und vorzugsweise in einer Schichtdicke von 10 bis 150 nm, besonders vorzugsweise von 30 bis 60 nm bereitgestellt sind, oder die eine Breite von 100 µm oder mehr aufweisen.

11. Folie (2) nach einem der Ansprüche 1 bis 10,
bei der die Funktionsschicht Metall-Nanodrähte, insbesondere aus Silber, Kupfer, Gold und/oder Metall-Nanopartikeln, insbesondere aus Silber, Kupfer oder Gold und/oder Kohlenstoff-Nanoröhrchen, Kohlenstoff-Nanopartikeln, Graphen und/oder organische Leiter wie PEDOT/PSS und/oder Polyanilin umfasst und/oder aktive elektrische Bauteile bereitstellt, insbesondere organische Leuchtdioden, anorganische oder organische Photovoltaikzellen, unter Einsatz von Elektrolumineszenzmaterialien, elektrochromen Materialien und/oder elektrophoretischen Materialien bereitgestellte Displayelemente, integrierte Schaltungen und/oder anorganische oder organische Speicher.

12. Folie (2) nach einem der vorhergehenden Ansprüche,
mit einem die Funktionsschicht (22) tragenden Substrat (21) aus Kunststoff, insbesondere aus Polyethylenterephtalat, Polypropylen, Polycarbonat, Polyethylennaphtalat, welches vorzugsweise in einer Dicke von zwischen 12 bis 150 µm, besonders bevorzugt von zwischen 35 bis 60 µm bereitgestellt ist.

13. Folie (2) nach einem der vorhergehenden Ansprüche,
bei der sich die Kontaktierungslasche verjüngt und bei dem die Funktionsschicht in dem Kontaktierungsbereich zu zumindest einem Anschluss eine Kontaktbahn (26, 26a) aufweist, die sich zu dem Übergangsbereich (20c') hin verbreitert.

14. Körper (1, 1', 1", 1'", 1^{iv}, 1 B) mit einer Folie (2) nach einem der Ansprüche 1 bis 13, die mit einem Kunststoffhauptmaterial (3) partiell so verbunden ist, dass der Kontaktierungsbereich (20b) zumindest teilweise von Kunststoffhauptmaterial (3) frei ist, so dass die Kontaktierungslasche wegsteht.

15. Körper (1, 1', 1", 1"') nach Anspruch 14 in dessen Rückbezug auf Patentanspruch 12 bei dem das Substrat (21) zwischen der Funktionsschicht (22) und dem Kunststoffhauptmaterial (3) angeordnet ist, oder bei dem die Funktionsschicht (22) zwischen dem Substrat (21) und dem Kunststoffhauptmaterial (3) angeordnet ist.

## Claims

1. Film (2) having at least one electric or electronic functional layer (22), wherein at least one electric and/or electronic component is provided in a functional region (20a, 20a') of the functional layer (22), and wherein at least one electric connection is provided in a contacting region (20b, 20b') of the at least one functional layer (22), said connection being galvanically coupled to at least one component and wherein the film (2) has a contacting tab that provides at least one part of the contacting region (20b, 20b'), wherein a further layer (23; 23a, 23b; 24; 24', 24") at a thickness of at least 300nm and preferably at least 1µm, particularly preferably at least 7µm, is applied to the functional layer (22) in a transition region (20c) between the functional region (20a) and the contacting region (20b), which comprises at least one partial region of the contacting tab, wherein the further layer comprises an electrically conductive material (23; 23; 23b).

2. Film (2) according to claim 1,
wherein the further layer comprises an electrically insulating material (24, 24', 24") which, in particular, comprises polymethyl (meth)acrylate, polycarbonate and/or acrylonitrile butadiene styrene and/or contains zinc oxide particles.

3. Film (2) according to claim 2,
wherein the electrically insulating material (24, 24', 24") is provided in the form of a varnish or is provided in the form a special film (24, 24') which, in particular, is fixed on the functional layer by means of an adhesive layer (27).

4. Film (2) according to one of claims 2 or 3,
wherein a substrate (21) carries the electric or electronic functional layer (22) and the electrically insulating material (24) has a thickness deviating from the thickness of the substrate (21) by +/-10% at most, or is harder or thinner than the substrate (21).

5. Film (2) according to one of the preceding claims,
wherein the contacting tab tapers away from the functional region in a transition region, reduces its width, in particular, by at least 20%, preferably at least 40% of a starting width.

6. Film (2) according to one of the preceding claims,
wherein the electrically conductive material (23; 23a, 23b) comprises conductive silver or carbon black.

7. Film (2) according to one of the preceding claims,
wherein electrically conductive material (23; 23b) is provided on a free end (20d) of the contacting tab and covers the electric connection of the functional layer (22).

8. Film (2) according to claim 7,
having a stiffening element (25) on the side of the film (2) facing away from the functional layer (22), said stiffening element (25) comprising, in particular, polyethylene terephthalate, polypropylene, polycarbonate or polyethylene naphthalate.

9. Film (2) according to claim 7 or 8 when referring directly or indirectly to claim 2, wherein the electrically conductive material (23a, 23b) is provided on the electric functional layer (22), in particular only regionally, and the electrically insulating material (24") covers the electrically conductive material (23a) in the transition region (20c), but releases the electrically conductive material (23b) on the free end (20d).

10. Film (2) according to one of the preceding claims.
wherein the functional layer (22) has a multitude of conductor tracks that consist of metal, in particular silver, copper, aluminium, chromium or a metal alloy, and which have a width of between 1 µm and 40 µm and have a distance relative to one another of between 10 µm and 5 mm and are preferably provided in a layer thickness of 10 to 150 nm, particularly preferably of 30 to 60 nm, or which have a width of 100 µm or more.

11. Film (2) according to one of claims 1 to 10,
wherein the functional layer comprises metal nanowires, in particular made of silver, copper, gold and/or metal nanoparticles, in particular made of silver, copper or gold and/or carbon nanotubes, carbon nanoparticles, graphene and/or organic conductors such as PEDOT:PSS and/or polyaniline, and/or provides active electric components, in particular organic light-emitting diodes, inorganic or organic photovoltaic cells, display elements provided using electroluminescent materials, electrochromic materials and/or electrophoretic materials, integrated circuits and/or inorganic or organic memories.

12. Film (2) according to one of the preceding claims,
having a substrate (21) made of plastic that carries the functional layer (22), in particular made of polyethylene terephthalate, polypropylene, polycarbonate, polyethylene naphthalate, which is preferably provided at a thickness of between 12 and 150 µm, particularly preferably of between 35 and 60 µm.

13. Film (2) according to one of the preceding claims,
wherein the contacting tab tapers and wherein the functional layer has a contact track (26, 26a) in the contacting region for at least one connection, said contact track (26, 26a) widening towards the transition region (20c').

14. Body (1, 1', 1", 1"', 1^{iv}, 1B) having a film (2) according to one of claims 1 to 13 that is partially connected to a plastic main material (3) in such a way that the contacting region (20b) is at least partially free from the plastic main material (3) such that the contacting tab protrudes.

15. Body (1, 1', 1", 1"') according to claim 14 when referring to claim 12,
wherein the substrate (21) is arranged between the functional layer (22) and the plastic main material (3), or wherein the functional layer (22) is arranged between the substrate (21) and the plastic main material (3).

## Revendications

1. Feuille (2) comportant au moins une couche fonctionnelle électrique ou électronique (22), dans laquelle dans une zone fonctionnelle (20a, 20a') de la couche fonctionnelle (22), au moins un élément constitutif électrique et/ou électronique est mis à disposition, et dans laquelle dans une plage de contact (20b, 20b') de l'au moins une couche fonctionnelle (22) au moins un raccordement électrique est prévu, qui est couplé par galvanisation à au moins un élément constitutif et dans laquelle la feuille (2) présente une languette de contact qui met à disposition au moins une partie de la zone de contact (20b, 20b'), dans laquelle sur la couche fonctionnelle (22) dans une zone de transition (20c) entre la zone fonctionnelle (20a) et la zone de contact (20b) qui comprend au moins une zone partielle de la languette de contact, une autre strate (23 ; 23a, 23b ; 24 ; 24', 24") est appliquée en une épaisseur d'au moins 300 nm et de préférence d'au moins 1 µm, de manière particulièrement préférée, d'au moins 7 µm, dans laquelle l'autre strate comprend un matériau électriquement conducteur (23 ; 23 ; 23b).

2. Feuille (2) selon la revendication 1,
dans laquelle l'autre strate comprend un matériau électriquement isolant (24, 24', 24") qui contient notamment du polyméthyl(méth)acrylate, du polycarbonate et/ou de l'acrylonitrilbutadiène-styrène et/ou contient des particules d'oxyde de zinc.

3. Feuille (2) selon la revendication 2,
dans laquelle le matériau électriquement isolant (24, 24', 24") est mis à disposition sous la forme d'une laque ou
est mis à disposition sous la forme d'une feuille séparée (24, 24') qui est fixée à la couche fonctionnelle notamment au moyen d'une couche d'adhésif (27).

4. Feuille (2) selon l'une des revendications 2 ou 3,
dans laquelle un substrat (21) porte la couche fonctionnelle (22) électrique ou électronique et le matériau électriquement isolant (24) présente une épaisseur différant au plus de +/- 10 % de la couche de substrat (21) ou est plus dure et plus fine que le substrat (21).

5. Feuille (2) selon l'une des revendications précédentes,
dans laquelle la languette de contact s'affine dans une zone de transition de la zone fonctionnelle, notamment sa largeur se réduit d'au moins 20 %, de préférence d'au moins 40 % d'une largeur initiale.

6. Feuille (2) selon l'une des revendications précédentes, dans laquelle le matériau électriquement conducteur (23 ; 23a, 23b) comprend de l'argent conducteur ou du noir de carbone.

7. Feuille (2) selon l'une des revendications précédentes,
dans laquelle le matériau électriquement conducteur (23 ; 23b) est mis à disposition sur une extrémité libre (20d) de la languette de contact et recouvre le raccordement électrique de la couche fonctionnelle (22).

8. Feuille (2) selon la revendication 7,
comportant un élément de rigidification (25) sur le côté de la feuille (2) détourné de la couche fonctionnelle (22) qui comprend notamment du polyéthylène téréphtalate, du polypropylène, du polycarbonate ou du polyéthylène naphtalate.

9. Feuille (2) selon la revendication 7 ou 8, dépendant directement ou indirectement de la revendication 2,
dans laquelle le matériau électriquement conducteur (23a, 23b) est mis à disposition sur la couche fonctionnelle (22) électronique, notamment uniquement par endroits, et le matériau isolant électrique (24") recouvre le matériau électriquement conducteur (23a) dans la zone de transition (20c) mais laisse découvert le matériau électriquement conducteur (23b) à son extrémité libre (20d).

10. Feuille (2) selon l'une des revendications précédentes,
dans laquelle la couche fonctionnelle (22) présente une multiplicité de pistes conductrices qui sont en métal, notamment en argent, cuivre, aluminium, chrome ou en un alliage métallique et qui présentent une largeur entre 1 µm et 40 µm et ont un intervalle entre elles entre 10 µm et 5 mm et de préférence en une épaisseur de couche de 10 à 150 nm, de manière particulièrement préférée, de 30 à 60 nm, ou qui présentent une largeur de 100 µm ou plus.

11. Feuille (2) selon l'une des revendications 1 à 10,
dans laquelle la couche fonctionnelle comprend des nanofils de métal, notamment, d'argent, de cuivre, d'or et/ou des nanoparticules de métal, notamment d'argent, de cuivre ou d'or et/ou des nanotubes de carbone, des nanoparticules de carbone, des graphes et/ou des conducteurs organiques tels que PEDOT/PSS et/ou de la polyaniline et/ou met à disposition des composants électriques actifs, notamment des diodes électroluminescentes organiques, des cellules photovoltaïques inorganiques ou organiques, en utilisant des matériaux électroluminescents, des matériaux électrochromes et/ou des matériaux électrophorétiques, des éléments d'affichage mis à disposition, des circuits intégrés et/ou des mémoires inorganiques ou organiques.

12. Feuille (2) selon l'une des revendications précédentes,
comportant un substrat (21) portant la couche fonctionnelle (22) en matière plastique, notamment en polyéthylène téréphtalate, polypropylène, polycarbonate, polyéthylène naphtalate qui est mis à disposition de préférence en une épaisseur entre 12 à 150 µm, de manière particulièrement préférée entre 35 et 60 µm.

13. Feuille (2) selon l'une des revendications précédentes,
dans laquelle la languette de contact s'affine et dans laquelle la couche fonctionnelle dans la zone de contact présente pour au moins un raccordement, une piste de contact (26, 26a) qui s'élargit en allant vers la zone de transition (20c').

14. Corps (1, 1', 1", 1"', 1^{iv}, 1B) comportant une feuille (2) selon l'une des revendications 1 à 13, qui est relié partiellement à un matériau principal en matière plastique (3), de sorte que la zone de contact (20b) soit dépourvue au moins partiellement du matériau principal en matière plastique (3) de sorte que la languette de contact dépasse.

15. Corps (1, 1', 1", 1"') selon la revendication 14, dépendant de la revendication 12,
dans lequel le substrat (21) est disposé entre la couche fonctionnelle (22) et le matériau principal en matière plastique (3) ou dans lequel la couche fonctionnelle (22) est disposée entre le substrat (21) et le matériau principal en matière plastique (3).
